(19) Europäisches Patentamt
European Patent Office
Office européen des brevets

(11) Veröffentlichungsnummer: **0 231 855 B1**

# (12) EUROPÄISCHE PATENTSCHRIFT

(45) Veröffentlichungstag der Patentschrift: **23.02.94**

(51) Int. Cl.[5]: **G03F 7/022**

(21) Anmeldenummer: **87101079.9**

(22) Anmeldetag: **27.01.87**

## (54) Neue Bis-1,2-naphtochinon-2-diazid-sulfonsäure-amide,ihre Verwendung in einem strahlungsempfindlichen Gemisch und strahlungsempfindliches Kopiermaterial.

(30) Priorität: **06.02.86 DE 3603578**

(43) Veröffentlichungstag der Anmeldung:
**12.08.87 Patentblatt 87/33**

(45) Bekanntmachung des Hinweises auf die Patenterteilung:
**23.02.94 Patentblatt 94/08**

(84) Benannte Vertragsstaaten:
**CH DE GB LI**

(56) Entgegenhaltungen:
**EP-A- 0 147 596**
**DE-A- 2 225 573**
**DE-C- 865 108**
**DE-C- 879 203**
**US-A- 3 046 110**
**US-A- 3 046 122**
**US-A- 3 687 663**

(73) Patentinhaber: **HOECHST AKTIENGESELLSCHAFT**

**D-65926 Frankfurt(DE)**

(72) Erfinder: **Zahn, Wolfgang, Dr.**
**Goetheweg 3**
**D-6228 Eltville-Erbach(DE)**
Erfinder: **Buhr, Gerhard, Dr.**
**Am Erdbeerstein 28**
**D-6240 Königstein 4(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services
(3.10/3.09/3.3.3)

## Beschreibung

Die Erfindung betrifft neue Bis-1,2-naphthochinon-2-diazid-sulfonsäureamide von sekundären Diaminen, ihre Verwendung in einem lichtempfindlichen Gemisch und strahlungsempfindliches Kopiermaterial.

Es ist bereits eine große Anzahl von Derivaten, vor allem aromatischen Estern, von 1,2-Naphthochinon-2-diazid-sulfonsäuren bekannt, die als lichtempfindliche Komponenten in positiv arbeitenden Kopiermaterialien verwendbar sind. In dem Buch von Jaromir Kosar: "Light-Sensitive Systems", John Wiley + Sons / New York, 1965, Seiten 343 bis 351, werden eine Reihe von lichtempfindlichen Naphthochinondiaziden beschrieben.

In der US-A 3 046 110 sind Ester bzw. Amide aus a) 1,2-Naphthochinon-2-diazid-4- oder -5-sulfonylchlorid und b) einem aromatischen Kohlenwasserstoff, der gleichzeitig mit Hydroxy- und Aminogruppen oder mit mehreren Aminogruppen substituiert ist, oder einem aliphatischen oder aliphatisch-aromatischen Diamin offenbart. Die Verbindungen werden als lichtempfindliche Beschichtung bei der Herstellung von Druckplatten verwendet.

Die fortschreitende Miniaturisierung bei der Herstellung von elektronischen Bauelementen erfordert die Erzeugung von immer kleineren Strukturen. Ein wichtiger Schritt bei der Herstellung derartiger Bauelemente ist die bildmäßige Belichtung und nachfolgende Entwicklung von lichtempfindlichen Filmen, die man auf das zu strukturierende Material aufträgt.

Die Wellenlänge des Lichtes, mit dem belichtet wird, ist ein limitierender Faktor für das Auflösungsvermögen lichtempfindlicher Schichten, und es können mit Licht kürzerer Wellenlänge Strukturen mit kleineren Dimensionen erzeugt werden. Die herkömmlich verwendeten Materialien zeigen jedoch nur im sichtbaren oder nahen UV-Bereich (365 - 450 nm) gute Lichtempfindlichkeit, während sie im kürzerwelligen Bereich (300 - 350 nm) nur unzureichende Lichtempfindlichkeit aufweisen. Die bisher verwendeten Naphthochinondiazid-Derivate besitzen im sogenannten MID-UV (300-350 nm) ungeeignete Absorptions-Eigenschaften, d.h. die Materialien werden durch Belichtung vor allem bei 313 nm nur wenig oder nicht ausgebleicht.

Der Einfluß von Substituenten in Naphthochinondiaziden auf die Absorption in diesem Bereich wurde bereits untersucht (Grant Willson, et al., Design of a positive resist for projection lithography in the MID-UV; Sixth International Technical Conference on Photopolymers, November 1982, Ellenville/USA), wobei gefunden wurde, daß Naphthochinondiazid-4- und - 5-alkylsulfonate günstige Absorptionseigenschaften im Bereich von 300 - 350 nm besitzen.

Die üblicherweise in den Belichtungsgeräten eingesetzten Quecksilberdampf-Lampen haben im Wellenlängenbereich von 300 - 350 nm zwei Emissions-Linien bei 313 nm und 334 nm, so daß eine Belichtung von geeigneten Materialien in diesem Wellenlängenbereich möglich ist.

Der Nachteil der unzureichenden Lichtempfindlichkeit bei Belichtung im MID-UV wurde bereits erkannt und in EP-A 0 085 761, entsprechend US Patentschrift Nr. 4,397,937 durch die Verwendung von Bis-1,2-naphthochinon-2-diazidsulfonsäureestern von aliphatischen Diolen zu überwinden versucht. Jedoch ist bisher nur eine sehr beschränkte Anzahl von trizyklischen Diolen genannt, deren Herstellung zudem nur unter Verwendung des sehr teuren Katalysators 4-Dimethylamino-pyridin möglich ist. Letzteres gilt auch für die in der EP-A 0 147 596 genannten aliphatischen Ester von Naphthochinondiazidsulfonsäuren, deren Darstellung nur unter Verwendung von 4-Dimethylaminopyridin oder 4-(1-Pyrrolidino)pyridin möglich ist.

Literaturbekannt ist generell die Labilität von Arylsulfonsäurealkylestern, die als Alkylierungsmittel Verwendung finden, z.B. zur Herstellung von Ethern (vgl. Houben-Weyl, Methoden der Organischen Chemie, Bd. IX, S. 674 ff., 4. Aufl. 1955; G. Thieme Verlag, Stuttgart).

Aufgabe der Erfindung ist es, neue, stabile 1,2-Naphthochinon-2-diazid-sulfonsäure-Derivate anzugeben, die als photoaktive Komponenten lichtempfindlichen Gemischen bei Belichtung im mittleren UV-Bereich (300 - 350 nm) eine bessere Lichtempfindlichkeit verleihen als es bisher bekannte Gemische aufweisen, wobei diese Gemische bei Belichtung im sichtbaren oder nahen UV-Bereich eine den derzeit verwendeten Gemischen zumindest vergleichbare oder auch bessere Lichtempfindlichkeit besitzen. Darüber hinaus sollten diese Derivate auch technisch einfach herstellbar sein.

Gegenstand der vorliegenden Erfindung sind Bis-1,2-naphthochinon-2-diazid-sulfonsäureamide von sekundären Diaminen, der allgemeinen Formel I,

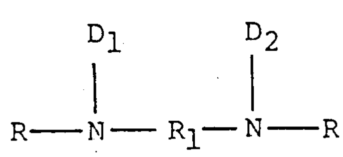

I

worin

R einen geradkettigen oder verzweigten, ggf. durch Hydroxyl substituierten Alkyl-, Cycloalkyl- oder Aralkylrest mit 1 - 14 Kohlenstoffatomen, dessen Kohlenstoffkette durch Ethersauerstoffatome unterbrochen sein kann,

$R_1$ einen Alkylenrest mit 2 - 12 Kohlenstoffatomen, dessen Kohlenstoffkette durch Ethersauerstoffatome unterbrochen ist, oder einen Arylendialkylrest mit 8 - 18 Kohlenstoffatomen, wobei im Fall mehrkerniger Verbindungen die aromatischen Glieder durch eine Einfachbindung, durch -O-, -S-, $-SO_2-$, -CO-, $-CR_2R_3-$, $-N[C_{1-3}$-Alkyl] CO- oder $C_{2-5}$-Alkyl, das durch Ethersauerstoffatome unterbrochen sein kann, verbunden sein Können, und

$R_2$ und $R_3$ gleich oder verschieden sein können und Wasserstoff oder ggf. substituierte Alkylreste mit 1 oder 2 Kohlenstoffatomen bedeuten,

oder

R und $R_1$ zusammen durch einen Cycloalkylrest mit 4 - 16 Kohlenstoffatomen gebildet werden, wobei bei mehrkernigen Verbindungen die Cycloaliphaten durch eine Kohlenstoffkette von 1 - 6 Kohlenstoffatomen verbunden sein können

und

$D_1$ und $D_2$ gleich oder verschieden sind und 1,2-Naphthochinon-2-diazid-4- bzw. 5-sulfonylreste bedeuten.

Bevorzugt sind solche Verbindungen der allgemeinen Formel I, worin

R einen geradkettigen oder verzweigten, ggf. mit Hydroxyl substituierten Alkyl- oder Cycloalkylrest mit 1 - 8, vorzugsweise mit 1 -4 Kohlenstoffatomen, dessen Kohlenstoffkette durch Ethersauerstoffatome unterbrochen sein kann, oder einen Aralkylrest mit 7 - 14 Kohlenstoffatomen,

$R_1$ einen Alkylenrest mit 2 - 10 Kohlenstoffatomen, dessen Kohlenstoffkette durch 1 oder 2 Ethersauerstoffatome unterbrochen ist, oder einen Arylendialkylrest mit 8 - 14 Kohlenstoffatomen, wobei im Fall mehrkerniger Verbindungen die aromatischen Glieder durch eine Einfachbindung, durch -O-, -S-, $-SO_2-$, -CO-, $-CR_2R_3-$, -N $[C_{1-2}$-Alkyl] CO- oder $C_{2-5}$-Alkyl, das durch Ethersauerstoffatome unterbrochen sein kann, verbunden sein können und

$R_2$ und $R_3$ gleich oder verschieden sind und Wasserstoff oder ggf. substituierte Alkylreste (z.B. mit einem oder mehreren Fluoratomen substituiert) mit 1 oder 2 Kohlenstoffatomen bedeuten,

oder

R und $R_1$ zusammen durch einen Cycloalkylrest mit 4 - 16 Kohlenstoffatomen gebildet werden können, wobei bei mehrkernigen Verbindungen die Cycloaliphaten durch eine Kohlenstoffkette von 1 - 6 Kohlenstoffatomen verbunden sein können,

und

$D_1$ und $D_2$ gleich oder verschieden sind, und 1,2-Naphthochinon-2-diazid-4- bzw. 5-sulfonylreste bedeuten.

Gegenstand der vorliegenden Erfindung ist auch die Verwendung der erfindungsgemäßen Bis-1,2-naphthochinon-2-diazid-sulfonsäureamide als strahlungsempfindliche Komponenten in einem strahlungsempfindlichen Gemisch und hieraus hergestelltes strahlungsempfindliches Kopiermaterial.

Die erfindungsgemäßen Naphthochinondiazid-Verbindungen finden als strahlungsempfindliche Komponente in strahlungsempfindlichen Gemischen Verwendung, wobei als strahlungsempfindliche Komponente 4- bzw. 5-Sulfonyl-Derivate allein oder im Gemisch oder 4,5-Mischsulfonyl-Derivate eingesetzt werden. Besonders bevorzugt ist der Einsatz in einem Gemisch von 4- und 5-Sulfonyl-Derivaten. Derartige Gemische oder auch die 4/5-Mischsulfonamide zeigen im mittleren UV-Bereich (300 - 350 nm), in dem die beiden Hg-Emissionslinien von 313 nm und 334 nm liegen, eine vorteilhafte und gleichförmige, hohe Absorption.

Hergestellt werden die erfindungsgemäßen Verbindungen nach bekannten Verfahren durch Umsetzung von sekundären Diaminen mit reaktiven Naphthochinondiazid-sulfonsäurederivaten, etwa dem Säurechlorid. Wegen der höheren Reaktivität der Amine gegenüber den Alkoholen kann die Herstellung kostengünstiger gestaltet werden, weil der Einsatz teurer Katalysatoren vermieden wird. Als bevorzugte Verfahren kommen die Umsetzungen in inerten Lösungsmitteln, wie Ketonen oder chlorierten Kohlenwasserstoffen, in Gegegenwart von anorganischen oder organischen Basen, wie Natriumcarbonat oder tertiären Aminen wie Triethylamin, in Betracht. Die erfindungsgemäßen Naphthochinondiazid-sulfonsäureamide können jedoch auch unter den Bedingungen der Phasen-Transfer-Katalyse, z.B. im System Methylenchlorid/wäßrige Lösung von Natriumcarbonat oder Tetraalkylammoniumhydroxid mit einem geeigneten Katalysator, wie Tetrabutylammoniumbromid, dargestellt werden.

Im folgenden wird eine allgemeine Vorschrift zur Herstellung der erfindungsgemäßen Naphthochinondiazidsulfonsäureamide gegeben:

0,2 Mol 1,2-Naphthochinon-2-diazid-sulfonsäurechlorid und 0,22 Mol Natriumcarbonat oder Triethylamin in 400 ml Aceton werden unter Rühren tropfenweise mit 0,1 Mol sekundärem Diamin versetzt, wobei man die Temperatur durch Kühlen unter 25 °C hält. Nach Beendigung des Zutropfens wird noch 1 Stunde weitergerührt

und

a) falls das Naphthochinondiazid-sulfonsäureamid bereits ausgefallen ist, dieses abgesaugt, mit kaltem Aceton und anschließend mit Wasser gewaschen und der Filterrückstand bei vermindertem Druck oder im Umluft-Trockenschrank bei mäßig erhöhter Temperatur getrocknet,

oder

b) bei im Reaktionsgemisch vollständig löslichen Bis-naphthochinondiazid-sulfonsäureamid, wird der Ansatz durch Absaugen von anorganischen Bestandteilen befreit. Das Filtrat wird in die zehnfache Menge 4 %iger wäßriger Salzsäure eingerührt, das ausgefallene Bis-sulfonsäureamid abfiltriert, mit Wasser säurefrei gewaschen und wie unter a) getrocknet.

Dabei werden die 1,2-Naphthochinon-2-diazid-sulfonamide in guten bis sehr guten, häufig fast quantitativen Ausbeuten erhalten. Die so hergestellten erfindungsgemäßen Verbindungen fallen so rein an, daß sich zur Verwendung in einem strahlungsempfindlichen Gemisch eine weitere Reinigung erübrigt. Die Reinheit ist häufig so gut, daß die experimentell bestimmten Werte der Verbrennungsanalyse den berechneten Werten entsprechen. In manchen Fällen ist jedoch eine Umkristallisation oder Umfällung in geeigneten Lösungsmitteln oder Lösungsmittelgemischen günstig.

Gegenstand der Erfindung ist auch ein strahlungsempfindliches Gemisch, enthaltend ein polymeres wasserunlösliches, in wäßrig-alkalischer Lösung lösliches oder quellbares harzartiges Bindemittel und ein 1,2-Naphthochinon-2-diazid-sulfonsäurederivat, dadurch gekennzeichnet, daß es als 1,2-Naphthochinon-2-diazid-sulfonsäurederivat mindestens eine Verbindung der oben genannten Formel I enthält,

worin

R einen geradkettigen oder verzweigten, ggf. durch Hydroxyl substituierten Alkyl-, Cycloalkyl- oder Aralkylrest mit 1 - 14 Kohlenstoffatomen, dessen Kohlenstoffkette durch Ethersauerstoffatome unterbrochen sein kann,

$R_1$ einen Alkylenrest mit 2 - 12 Kohlenstoffatomen, dessen Kohlenstoffkette durch Ethersauerstoffatome unterbrochen ist, oder einen Arylendialkylrest mit 8 - 18 Kohlenstoffatomen, wobei im Fall mehrkerniger Verbindungen die aromatischen Glieder durch eine Einfachbindung, durch -O-, -S-, $-SO_2-$, -CO-, $-CR_2R_3-$, -N[$C_{1-3}$-Alkyl] CO- oder $C_{2-5}$-Alkyl, das durch Ethersauerstoffatome unterbrochen sein kann, verbunden sein können, und

$R_2$ und $R_3$ gleich oder verschieden sein können und Wasserstoff oder ggf. substituierte Alkylreste mit 1 oder 2 Kohlenstoffatomen bedeuten,

oder

R und $R_1$ zusammen durch einen Cycloalkylrest mit 4 - 16 Kohlenstoffatomen gebildet werden, wobei bei mehrkernigen Verbindungen die Cycloaliphaten durch eine Kohlenstoffkette von 1 - 6 Kohlenstoffatomen verbunden sein können

und

$D_1$ und $D_2$ gleich oder verschieden sind und 1,2-Naphthochinon-2-diazid-4- bzw. 5-sulfonylreste bedeuten.

Bevorzugt sind Gemische, in denen

R einen geradkettigen oder verzweigten, ggf. mit Hydroxyl substituierten Alkyl- oder Cycloalkylrest mit 1 - 8, vorzugsweise mit 1 -4 Kohlenstoffatomen, dessen Kohlenstoffkette durch Ethersauerstoffatome unterbrochen sein kann, oder einen Aralkylrest mit 7 - 14 Kohlenstoffatomen,

$R_1$ einen Alkylenrest mit 2 - 10 Kohlenstoffatomen, dessen Kohlenstoffkette durch 1 oder 2 Ethersauerstoffatome unterbrochen ist, oder einen Arylendialkylrest mit 8 - 14 Kohlenstoffatomen, wobei im Fall mehrkerniger Verbindungen die aromatischen Glieder durch eine Einfachbindung, durch -O-, -S-, $-SO_2-$, -CO-, $-CR_2R_3-$, -N [$C_{1-2}$-Alkyl] CO- oder $C_{2-5}$-Alkyl, das durch Ethersauerstoffatome unterbrochen sein kann, verbunden sein können und

$R_2$ und $R_3$ gleich oder verschieden sind und Wasserstoff oder ggf. substituierte Alkylreste (z.B. mit einem oder mehreren Fluoratomen substituiert) mit 1 oder 2 Kohlenstoffatomen bedeuten,

oder

R und $R_1$ zusammen durch einen Cycloalkylrest mit 4 - 16 Kohlenstoffatomen gebildet werden

können, wobei bei mehrkernigen Verbindungen die Cycloaliphaten durch eine Kohlenstoffkette von 1 - 6 Kohlenstoffatomen verbunden sein können,

und

$D_1$ und $D_2$ gleich oder verschieden sind, und 1,2-Naphthochinon-2-diazid-4- bzw. 5-sulfonylreste bedeuten.

Die erfindungsgemäßen strahlungsempfindlichen Gemische zeichnen sich durch eine hohe praktische Lichtempfindlichkeit aus, die im sichtbaren oder nahen UV-Bereich den herkömmlichen Systemen generell überlegen ist und im MID-UV-Bereich deutlich besser ist als die der bisher bekannten Systeme. Mit den erfindungsgemäßen Naphthochinondiazid-Verbindungen formulierte strahlungsempfindliche Gemische zeigen auch gegenüber hochenergetischer Strahlung, z.B. Elektronenstrahlen oder Röntgenstrahlen, gute Empfindlichkeiten und bringen gute lithographische Ergebnisse. Außerdem werden mit den strahlungsempfindlichen schichten sehr gute Kontrast-Werte erzielt.

Gute Lichtempfindlichkeit des Gemisches ist bei der Fertigung mikroelektronischer Schaltkreise oder Bauelemente ein wesentlicher Faktor, vor allem bei der sog. "in-line"-Verarbeitung von Wafern, bei welcher der Durchsatz der Scheiben von dem am längsten dauernden Prozeßschritt bestimmt wird. Ein kritischer Punkt dabei sind die Belichtungszeiten, d.h. der Durchsatz am Belichtungsgerät. Vor allem bei monochromatischer Bestrahlung oder bei Belichtung mit kürzerwelligem aktinischem Licht führte dies bisher meist zu unbefriedigenden Taktzeiten und somit zu ungenügendem Durchsatz von Wafern, was letztlich eine nicht akzeptable, langsame Produktions-Geschwindigkeit zur Folge hatte.

Die Konzentration der erfindungsgemäßen Naphthochinondiazid-sulfonsäureamide in dem strahlungsempfindlichen Gemisch kann in relativ weiten Grenzen schwanken. Im allgemeinen liegt der Anteil bei 4 % bis 40 %, vorzugsweise zwischen 6 % und 25 % bezogen auf das Gewicht des Feststoffanteils des Gemisches.

Die erfindungsgemäßen lichtempfindlichen Gemische enthalten ferner ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Zusatz auch bei den erfindungsgemäßen Gemischen mit den neuen Naphthochinondiazidsulfonsäureamiden als besonders brauchbar und vorteilhaft erwiesen. Die Art und Menge der Novolak-Harze kann je nach Anwendungszweck verschieden sein. Bevorzugt sind Novolak-Anteile am Gesamtfeststoff zwischen 60 % und 96%, besonders bevorzugt 75 - 95 %. In geringen Mengen kann das lichtempfindliche Gemisch für spezielle Erfordernisse wie Haftung, Glätte der Oberfläche, spezielle Absorptions-Eigenschaften etc. noch Substanzen wie Netzmittel, Haftvermittler und Farbstoffe enthalten.

Ebenfalls als Bindemittel geeignet sind polymere Bindemittel mit seitenkettenständigen phenolischen Hydroxylgruppen, wie zum Beispiel Vinylphenole oder die Ester und Amide von Acrylsäure und Methacrylsäure mit zum Beispiel Hydrochinon, Brenzkatechin, Resorcin, Pyrogallol oder Hydroxyphenyl-amin. Neben den Homopolymeren können auch Copolymere der genannten Monomeren untereinander oder auch mit anderen polymerisierbaren Monomeren, wie Styrol, Methacrylsäuremethacrylat, Acrylsäuremethacrylat, Biphenylol-methacrylat oder Biphenylolacrylat als Bindemittel in den erfindungsgemäßen Gemischen verwendet werden. Auch Mischungen der Polymerisate mit Novolaken sind einsetzbar. Die Art und Menge der Bindemittel kann je nach Anwendungszweck verschieden sein, entspricht jedoch weitgehend den für Novolak angegebenen Bereichen.

Zur Beschichtung eines geeigneten Schichtträgers für die Herstellung des erfindungsgemäßen Kopiermaterials werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon oder N-Methyl-pyrrolidon, Alkoholether wie Ethylenglykol-monoethylether oder Propylenglykol-monoethylether, Alkoholether-acetate wie Ethylenglykol-monoethyletheracetat oder Propylenglykol-monoethylether-acetat, und Ester wie Butylacetat. Es können auch Gemische von Lösungsmitteln verwendet werden, die u.a. auch Xylol enthalten können. Prinzipiell sind alle Lösungsmittel verwendbar, die mit den Schichtkomponenten nicht irreversibel reagieren.

Die erfindungsgemäßen Gemische lassen sich in Kopiermaterialien wie Photoresists für die Mikroelektronik-Industrie verwenden. Als bevorzugte Schichtträger kommen Silicium-Scheiben in Betracht, die auch oberflächlich oxidiert sein können. Die während der üblichen mikroelektronischen Fertigungsprozesse auftretenden Schichten, wie z.B. Siliciumnitrid, Polysilicium, Siliciumoxid, Polyimide oder Metalle wie Aluminium und auch mit geeigneten Dotierungsmaterialien implantiertes Silicium sind als Schichtträger für die erfindungsgemäßen Gemische ebenfalls geeignet. Auch Scheiben aus GaAs-Legierungen stellen geeignete Schichtträger dar. Weiterhin können die erfindungsgemäßen Gemische in der Leiterplattenfertigung verwendet werden, wobei die hierfür üblichen Schichtträger Verwendung finden. Als Schichtträger kommen auch Aluminium-Platten, die eine geeignete Vorbehandlung erfahren haben und zur Herstellung von Druckplatten geeignet sind, in Betracht.

Die Beschichtung der in der Mikroelektronik-Industrie üblichen Schichtträger erfolgt in bekannter Weise durch Aufschleudern. Für diese und andere Schichtträger kommen jedoch auch Beschichtungstechniken wie Sprühen, Walzen, Tauchen, mittels Breitschlitzdüsen, Bakeln oder durch Gießer-Antrag in Betracht.

Belichtet wird mit üblichen Lichtquellen, wobei besonders vorteilhaft Belichtungsgeräte verwendet werden können, deren optische Systeme nur für aktinisches Licht des MID-UV-Bereiches durchlässig sind.

Die zum Entwickeln verwendeten wäßrig-alkalischen Lösungen, die auch kleinere Mengen Netzmittel enthalten können, entfernen die vom Licht getroffenen Stellen der lichtempfindlichen Schicht und erzeugen so ein positives Abbild der Vorlage.

Bevorzugte Anwendung finden die erfindungsgemäßen strahlungsempfindlichen Gemische bei lithographischen Prozessen bei der Herstellung von integrierten Schaltungen oder von diskreten elektrischen Bausteinen. Sie dienen dabei als Maskierungsmaterial für verschiedene Prozeß-Schritte, wie zum Beispiel Ätzen des Schichtträgers, Implantation von Ionen in den Schichtträger oder Abscheidung von Materialien auf den Schichtträger.

Zum Vergleich der Lichtempfindlichkeiten wurden die Photoresist-Formulierung, d.h. das Gewichts-Verhältnis von strahlungsempfindlicher Komponente zu Bindemittel, und der Entwickler so gewählt, daß beim Entwicklungsvorgang die erfindungsgemäßen Gemische immer etwa den gleichen Dunkelabtrag aufwiesen wie der Vergleichsresist, der in dem für ihn üblichen Entwickler entwickelt wurde. Als Dunkelabtrag bezeichnet man die Verminderung der Schichtdicke einer lichtempfindlichen Schicht, die durch die meist geringe Löslichkeit der Schicht auch an den unbelichteten Stellen im Entwickler während des Entwicklungsvorgangs hervorgerufen wird. Der Vergleich wurde immer bei gleichen Schichtdicken durchgeführt. Eine Einstellung der Schichtdicke erfolgte durch Wahl des geeigneten Feststoffgehaltes.

Die strahlungsempfindlichen Gemische wurden nach Filtration durch Aufschleudern auf geeignete Schichtträger, wie Silicium-Scheiben, aufgebracht. Die Einstellung der Drehzahl der Beschichtungs-Schleuder erlaubt eine genaue Einstellung der Schichtdicke der Photolacke. Getrocknet wurden die Schichten 30 Minuten bei 90 °C im Umluft-Trockenschrank. Nach dem Trocknungsprozeß betrugen die Schichtdicken der zum Lichtempfindlichkeits-Vergleich verwendeten Photolacke 1,0 µm.

Selbstverständlich können mit den erfindungsgemäßen Gemischen auch kleinere und größere Schichtdicken hergestellt werden, wobei je nach Verwendungszweck das Verhältnis der strahlungsempfindlichen Komponente zum Bindemittel und der Gesamt-Feststoffgehalt angepaßt werden müssen, um optimale lithographische Ergebnisse zu erhalten.

Die Lichtempfindlichkeits-Vergleiche wurden durchgeführt bei Belichtung mit den herkömmlichen Wellenlängen (365 - 436 nm) und in MID-UV-Bereich (300 - 350 nm). Belichtet wurde mit Kontakt-Belichtungsgeräten der Fa. Süss GmbH und Co. Die Belichtungsleistung wurde gemessen mit einem Optical Associates Model 205 UV Powermeter, das mit für die Belichtungswellenlängen-Bereiche geeigneten Sensoren ausgestattet war. In den Belichtungsgeräten waren Hg-Lampen und eine geeignete Optik zum Abtrennen bestimmter Wellenlängen-Bereiche installiert. Die Photolacke belichtete man bei gleichbleibender Belichtungsleistung unterschiedliche Zeiten lang und entwickelte anschließend in einem geeigneten Entwickler, wobei die Entwicklungszeiten gleich lang waren. Geeignete Entwickler sind wäßrig-alkalische Lösungen, die metallionenfrei sind, aber auch Metall-Ionen wie Natrium und/oder Kaliumionen enthalten können. Die Entwickler-Lösungen können gepuffert sein, zum Beispiel mit Silikat-, Borat- oder Phosphat-Lösungen oder geeigneten Mischungen von Salzlösungen, und auch geringe Mengen von Tensiden enthalten.

Als Maß der Lichtempfindlichkeit wurde der Wert der Belichtungsenergiedichte verwendet, die notwendig war, um während des Entwicklungs-Vorganges 0,5 µm der strahlungsempfindlichen Schicht abzulösen. Die Schichtdicken wurden mit den Schichtdicken-Meßgeräten Sloan Dektak I bzw. Dektak II oder Rudolph FTM gemessen.

Die erfindungsgemäßen strahlungsempfindlichen Gemische zeigen unter den genannten Bedingungen bei Belichtung im sichtbaren oder nahen UV-Bereich gegenüber den herkömmlichen Photolacken eine zumindest vergleichbare, meist bessere Lichtempfindlichkeit und bei Belichtung im MID-UV-Bereich eine deutlich gesteigerte Lichtempfindlichkeit, die etwa um den Faktor 2 größer ist als die eines herkömmlichen Photolackes.

Im folgenden werden Beispiele der erfindungsgemäßen bzw. der in den erfindungsgemäßen Gemischen eingesetzten Bis-1,2-naphthochinon-2-diazid-sulfonsäureamide und von den erfindungsgemäßen lichtempfindlichen Gemischen gebracht, wobei der Erfindungsgedanke jedoch nicht hierauf beschränkt ist.

Beispiele 1 - 44 siehe Tabelle I

Tabelle 1

$$R-\underset{}{\overset{D}{N}}-R_1-\overset{D}{N}-R$$

| Nr. | R | $R_1$ | D | Analyse [%] $S_{ber.}$ | Analyse [%] $S_{gef.}$ |
|---|---|---|---|---|---|
| 1 | $-CH_3$ | $-(CH_2)_2-$ | 1 | 11,61 | 11,2 |
| 2 | $-CH_3$ | $-(CH_2)_2-$ | 2 | 11,61 | 10,7 |
| 3 | $-CH_3$ | $-(CH_2)_6-$ | 1 | 10,54 | 10,6 |
| 4 | $-CH_3$ | $-(CH_2)_6-$ | 2 | 10,54 | 10,5 |
| 5 | $-CH_3$ | $-(CH_2)_{10}-$ | 1 | 9,65 | 9,5 |
| 6 | $-CH_3$ | $-(CH_2)_{10}-$ | 2 | 9,65 | 9,8 |
| 7 | $-CH_3$ | $-CH_2-CH_2-O-CH_2-CH_2-O-CH_2-CH_2-$ | 1 | 10,01 | 9,3 |
| 8 | $-CH_3$ | $-CH_2-CH_2-O-CH_2-CH_2-O-CH_2-CH_2-$ | 2 | 10,01 | 9,8 |
| 9 | $-CH_3$ | $-CH_2-CH_2-O-CH_2-CH_2-O-CH_2-CH_2-$ | 3 | 10,01 | 10,0 |
| 10 | $-CH_3$ | 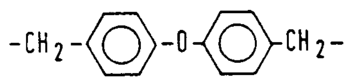 | 1 | 8,90 | 8,6 |
| 11 | $-CH_3$ | 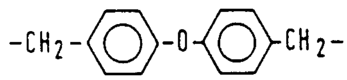 | 2 | 8,90 | 8,7 |
| 12 | $-CH_2-CH_2-CH_3$ | $-(CH_2)_{10}-$ | 1 | 8,90 | 9,0 |
| 13 | $-CH_2-CH_2-CH_3$ | $-(CH_2)_{10}-$ | 2 | 8,90 | 8,9 |
| 14 | $-CH_2-CH_2-CH_3$ | $-CH_2-CH_2-O-CH_2-CH_2-O-CH_2-CH_2-$ | 1 | 9,20 | 9,3 |
| 15 | $-CH_2-CH_2-CH_3$ | $-CH_2-CH_2-O-CH_2-CH_2-O-CH_2-CH_2-$ | 2 | 9,20 | 8,7 |
| 16 | $-CH_2-CH_2-CH_3$ | 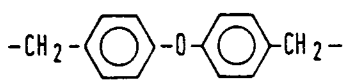 | 1 | 8,25 | 8,1 |
| 17 | $-CH_2-CH_2-CH_3$ | 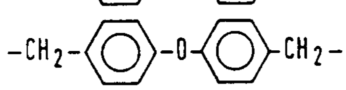 | 2 | 8,25 | 8,4 |
| 18 | $-CH_2-CH_2-CH_3$ | 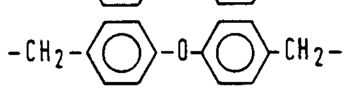 | 3 | 8,25 | 7,9 |
| 19 | $-CH(CH_3)_2$ | $-(CH_2)_{10}-$ | 1 | 8,90 | 9,0 |
| 20 | $-CH(CH_3)_2$ | $-(CH_2)_{10}-$ | 2 | 8,90 | 9,3 |
| 21 | $-CH(CH_3)_2$ | $-CH_2-CH_2-O-CH_2-CH_2-O-CH_2-CH_2-$ | 1 | 9,20 | 9,2 |
| 22 | $-CH(CH_3)_2$ | $-CH_2-CH_2-O-CH_2-CH_2-O-CH_2-CH_2-$ | 2 | 9,20 | 8,6 |

1) 1,2-Naphthochinondiazid (2)-5-sulfonyl

2) 1,2-Naphthochinondiazid (2)-4-sulfonyl

3) 1,2-Naphthochinondiazid (2)-4-sulfonyl und -5-sulfonyl

Tabelle 1 (Fortsetzung)

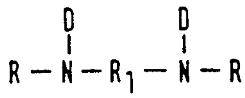

| Nr. | R | $R_1$ | D | Analyse [%] $S_{ber.}$ | $S_{gef.}$ |
|---|---|---|---|---|---|
| 23 | $-CH(CH_3)_2$ | 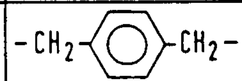 | 1 | 9,36 | 9,2 |
| 24 | $-CH(CH_3)_2$ | 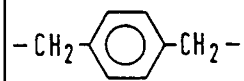 | 2 | 9,36 | 9,3 |
| 25 | $-CH(CH_3)_2$ | 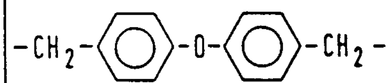 | 1 | 8,25 | 8,2 |
| 26 | $-CH(CH_3)_2$ | 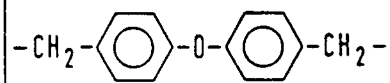 | 2 | 8,25 | 8,1 |
| 27 | $-CH(CH_3)_2$ | 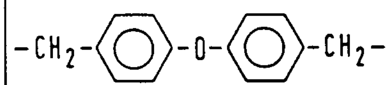 | 3 | 8,25 | 8,3 |
| 28 | $-CH_2-CH(CH_3)_2$ | $-(CH_2)_{10}-$ | 1 | 8,56 | 8,5 |
| 29 | $-CH_2-CH(CH_3)_2$ | $-(CH_2)_{10}-$ | 2 | 8,56 | 8,3 |
| 30 | $-CH_2-CH(CH_3)_2$ | 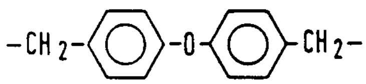 | 1 | 7,97 | 8,0 |
| 31 | $-CH_2-CH(CH_3)_2$ | 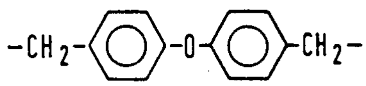 | 2 | 7,97 | 7,9 |
| 32 | $-CH_2-(CH_2)_6-CH_3$ | 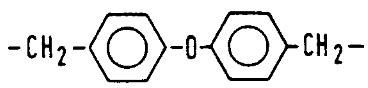 | 1 | 6,99 | 6,5 |
| 33 | $-CH_2-(CH_2)_6-CH_3$ | 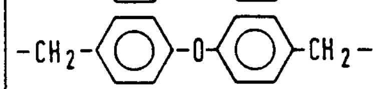 | 2 | 6,99 | 6,9 |
| 34 | | 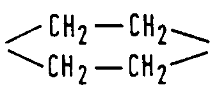 | 1 | 11,64 | 11,6 |
| 35 | | | 2 | 11,64 | 11,4 |
| 36 | | 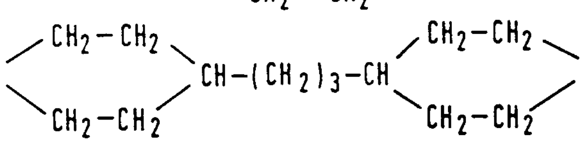 | 1 | 9,50 | 9,6 |
| 37 | | | 2 | 9,50 | 9,4 |

1) 1,2-Naphthochinondiazid (2)-5-sulfonyl
2) 1,2-Naphthochinondiazid (2)-4-sulfonyl
3) 1,2-Naphthochinondiazid (2)-4-sulfonyl und -5-sulfonyl

Tabelle 1 (Fortsetzung)

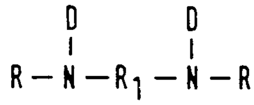

| Nr. | R | $R_1$ | D | Analyse [%] $S_{ber.}$ | $S_{gef.}$ |
|---|---|---|---|---|---|
| 38 | 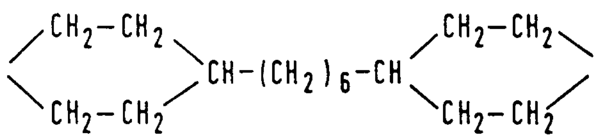 | | 1 | 8,95 | 9,0 |
| 39 | | | 2 | 8,95 | 8,9 |
| 40 | $H_3C-O-CH_2-CH_2-$ | 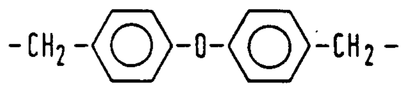 | 1 | 7,93 | 7,6 |
| 41 | $H_3C-O-CH_2-CH_2-$ | 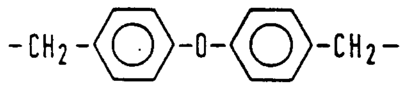 | 2 | 7,93 | 7,9 |
| 42 | 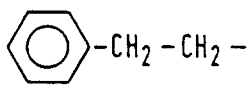 | 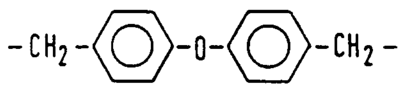 | 1 | 7,12 | 7,1 |
| 43 | 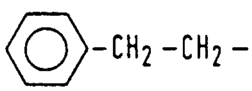 | 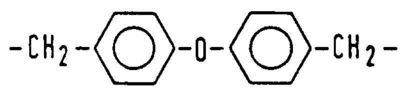 | 2 | 7,12 | 7,0 |
| 44 | 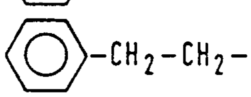 | 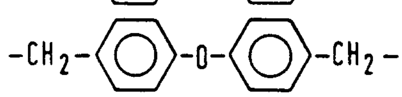 | 3 | 7,12 | 6,3 |

1) 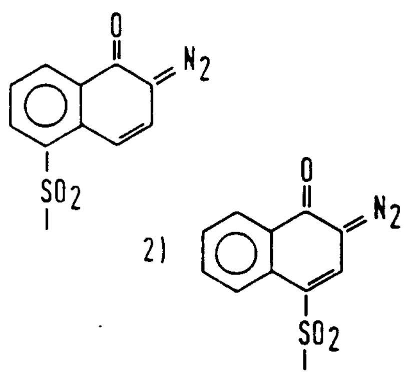 2)

1) 1,2-Naphthochinondiazid (2)-5-sulfonyl
2) 1,2-Naphthochinondiazid (2)-4-sulfonyl
3) 1,2-Naphthochinondiazid (2)-4-sulfonyl und -5-sulfonyl

Beispiel 45

Eine Silicium-Scheibe wird mit einer Beschichtungslösung, bestehend aus

21,24 Gewichtsteil Kresol-Formaldehyd-Novolak (Schmelzbereich 106 °C -115 °C nach DIN 53181),
0,88 Gewichtsteil Verbindung 21,

0,88 Gewichtsteil Verbindung 24 und
77,00 Gewichtsteil Propylenglykol-monomethyletheracetat,
schleuderbeschichtet, so daß sich nach dem Trocknen eine Schichtdicke von 1,0 µm ergibt. Die Schicht wird bei gleichbleibender Belichtungsleistung unterschiedliche Zeiten lang belichtet und anschließend in 0,530 n gepufferter NaOH entwickelt. Die Energiedichte, die notwendig ist, um 0,5 µm der Schicht durch den Entwicklungsprozeß ablösen zu können, ist nach Belichtung im MID-UV-Bereich um 50 % geringer und nach Belichtung bei 365-436 nm um 25 % geringer als die für einen herkömmlichen Photolack nötige Energiedichte. Ein ähnliches Ergebnis wird erhalten, wenn man in obiger Mischung die Verbindung 21 durch Verbindung 5 und die Verbindung 24 durch Verbindung 6 ersetzt. Der genannte herkömmliche Photolack besitzt in einer 31 %igen Lösung einen bezogenen dekadischen Absorptionskoeffizienten von 0,74. Sein Feststoffanteil besteht aus einem Kresol-Formaldehyd-Novolak und geeigneten Naphthochinondiazid-Derivaten.

Beispiel 46

Eine Silicium-Scheibe wird mit einer Beschichtungslösung, bestehend aus
22,22 Gewichtsteil Kresol-Formaldehyd-Novolak (Schmelzbereich 122 °C - 132 °C nach DIN 53181),
1,39 Gewichtsteil Verbindung 17,
1,39 Gewichtsteil Verbindung 25 und
75,00 Gewichtsteil Propylenglykol-monomethyletheracetat,
schleuderbeschichtet, so daß sich nach dem Trocknen eine Schichtdicke von 1,0 µm ergibt. Die Belichtung erfolgt wie in Beispiel 45; die Entwicklung wird in 0,478 n gepufferter NaOH durchgeführt. Die Energiedichte, die notwendig ist, um 0,5 µm der Schicht durch den Entwicklungsprozeß ablösen zu können, ist nach Belichtung im MID-UV-Bereich um 50 % geringer und nach Belichtung bei 365 - 436 nm um 30 % geringer als die für einen herkömmlichen Photolack (siehe Beispiel 45) nötige Energiedichte. Ähnliche Ergebnisse werden erhalten, wenn man die genannte Kombination der Verbindungen 17 und 25 ersetzt durch entsprechende Gemische der Verbindungen 30/31, 16/17 oder 25/26 oder auch durch die Verbindungen 9, 18 oder 27. Dabei kann der Feststoffgehalt der Beschichtungslösungen unterschiedlich sein. Die Entwickler-Normalität muß dem jeweiligen Gemisch angepaßt werden.

Beispiel 47

Eine Silicium-Scheibe wird mit einer Beschichtungslösung, bestehend aus
18,67 Gewichtsteil Kresol-Formaldehyd-Novolak (Schmelzbereich 122 °C - 132 °C nach DIN 53181),
2,33 Gewichtsteil Verbindung 6 und
79,00 Gewichtsteil Propylenglykol-monomethyletheracetat,
schleuderbeschichtet, so daß sich nach dem Trocknen eine Schichtdicke von 1,0 µm ergibt. Die Belichtung erfolgt wie in Beispiel 45 angegeben. Die Entwicklung wird in 0,484 n gepufferter NaOH durchgeführt. Nach Belichtung im MID-UV-Bereich ist die notwendige Energiedichte, um 0,5 µm der Schicht durch den Entwicklungsprozeß ablösen zu können, um 45 % geringer und nach Belichtung bei 365 - 436 nm um 25 % geringer als die für einen herkömmlichen Photolack (siehe Beispiel 45) nötige Energiedichte. Verbindung 6 kann ersetzt werden durch die Verbindungen 5, 16, 17, 21, 22, 25 oder 26, wobei wiederum die Entwickler-Normalitäten angepaßt werden müssen.

Beispiel 48

Eine Silicium-Scheibe wird mit einer Beschichtungslösung, bestehend aus
13,9 Gewichtsteil Polybrenzkatechin-monomethacrylat,
2,8 Gewichtsteil Verbindung 42 und
83,3 Gewichtsteil Propylenglykol-monomethyletheracetat
schleuderbeschichtet, so daß sich nach dem Trocknen eine Schichtdicke von 1,0 µm ergibt. Die erhaltene Schicht zeichnet sich nach Belichtung durch gute Löslichkeit in 0,36 n NaOH aus, bei niedriger Löslichkeit in den unbelichteten Schichtbereichen. Verbindung 42 kann u.a. ersetzt werden durch die Verbindungen 5, 13, 19, 20, 23, 32 oder 40 oder auch durch Mischungen von Naphthochinon-4- und 5-sulfonyl-Derivaten, wie zum Beispiel 28/29, wobei die Entwickler-Normalitäten angepaßt werden müssen.

Beispeil 49

Auf einen elektrolytisch aufgerauhten und anodisierten Aluminium-Schichtträger wird eine Beschichtungslösung, bestehend aus

| | |
|---|---|
| 7,60 Gewichtsteil | Kresol-Formaldehyd-Novolak (Schmelzbereich 106 °C - 115 °C nach DIN 53181), |
| 0,96 Gewichtsteil | Verbindung 21 und |
| 91,44 Gewichtsteil | eines Lösungsmittelgemisches aus Ethylenglykol-monoethyletheracetat, Butylacetat und Xylol im Gew.-Verhältnis von 9:1:1, |

aufgebracht, so daß sich nach dem Trocknen ein Schichtgewicht von 2,34 g/m[2] ergibt. Nach dem Trocknen wird die beschichtete Druckplatte unter einer positiven Halbtonvorlage, die 13 gleiche Dichtestreifen von 0,15 bis 1,95 aufweist, mit einer 5 kW-Metallhalogenidlampe im Abstand von 120 cm 10 Sekunden lang belichtet und mit einem Entwickler, bestehend aus

| | |
|---|---|
| 5,3 Gewichtsteil | Natriummetasilikat • 9 $H_2O$, |
| 3,4 Gewichtsteil | Trinatriumphosphat • 12 $H_2O$, |
| 0,3 Gewichtsteil | Natriumdihydrogenphosphat (wasserfrei) und |
| 91,0 Gewichtsteil | Wasser |

1 Minute lang entwickelt, wobei die belichteten Schichtbereiche entfernt werden. Man erhält ein Druckbild mit steiler Gradation und 4 Keilstufen. Ein ähnliches Ergebnis erhält man, wenn in der genannten Rezeptur die Verbindung 21 durch die Verbindungen 5, 7, 10, 14, 23 oder 30 oder durch Gemische von 14/15, 16/17 oder 28/29 (jeweils 0,48 Gewichtsteil von einer der beiden strahlungsempfindlichen Komponenten) ersetzt wird.

Beispiel 50

Eine Lösung von

| | |
|---|---|
| 3,9 Gewichtsteil | der Verbindung 40 oder 42, |
| 19,5 Gewichtsteil | Kresol-Formaldehyd-Novolak (Schmelzbereich 106 °C - 115 °C nach DIN 53181), |
| 6,5 Gewichtsteil | Polyvinylmethylether (mit einem K-Wert von 45 - 55), |
| 0,4 Gewichtsteil | des Farbstoffes Sudanblau II (C.I. Solvent Blue 35) |
| | in |
| 49,7 Gewichtsteil | Propylenglykolmonoethyletheracetat, |
| 10,0 Gewichtsteil | Propylenglykolmonoethylether und |
| 10,0 Gewichtsteil | Butylacetat |

ergibt einen Kopierlack, der sich für die Fertigung von Leiterplatten gut eignet. Der Kopierlack kann u.a. durch Walzen-Antrag auf Kupferplatten oder andere für die Leiterplatten-Fertigung geeignete Substrate aufgebracht werden.

**Patentansprüche**

**1.** Bis-1,2-naphthochinon-2-diazid-sulfonsäureamide von sekundären Diaminen der allgemeinen Formel I,

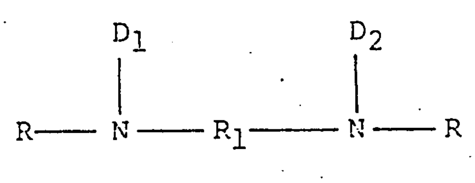

I

worin

| | |
|---|---|
| R | einen geradkettigen oder verzweigten, ggf. durch Hydroxyl substituierten Alkyl-, Cycloalkyl- oder Aralkyl-Rest mit 1 - 14 Kohlenstoffatomen, dessen Kohlenstoffkette durch Ethersauerstoffatome unterbrochen sein kann, |
| $R_1$ | einen Alkylenrest mit 2 - 12 Kohlenstoffatomen, dessen Kohlenstoffkette durch Ethersauerstoffatome unterbrochen ist, oder einen Arylendialkylrest mit 8 - 18 Kohlenstoffatomen, wobei im Fall mehrkerniger Verbindungen die aromatischen Glieder durch eine Einfachbindung, durch -O-, -S-, $-SO_2-$, -CO-, $-CR_2R_3-$, -N $[C_{1-3}$-Alkyl]-CO- oder $C_{2-5}$-Alkyl, das durch Ethersauerstoffatome unterbrochen sein kann, verbunden sein können, und |

$R_2$ und $R_3$ gleich oder verschieden sein können und Wasserstoff oder ggf. substituierte Alkylreste mit 1 oder 2 Kohlenstoffatomen bedeuten,

oder

R und $R_1$ zusammen durch einen Cycloalkylrest mit 4 - 16 Kohlenstoffatomen gebildet werden, wobei bei mehrkernigen Verbindungen die Cycloaliphaten durch eine Kohlenstoffkette von 1 - 6 Kohlenstoffatomen verbunden sein können

und

$D_1$ und $D_2$ gleich oder verschieden sind und 1,2-Naphthochinon-2-diazid-4- bzw. 5-sulfonylreste bedeuten.

**2.** Bis-1,2-naphthochinon-2-diazid-sulfonsäureamide von sekundären Diaminen der allgemeinen Formel I nach Anspruch 1, worin

R einen geradkettigen oder verzweigten, ggf. durch Hydroxyl substituierten Alkyl- oder Cycloalkylrest mit 1 - 8, vorzugsweise mit 1 - 4 Kohlenstoffatomen, dessen Kohlenstoffkette durch Ethersauerstoffatome unterbrochen sein kann, oder einen Aralkylrest mit 7 - 14 Kohlenstoffatomen,

$R_1$ einen Alkylenrest mit 2 - 10 Kohlenstoffatomen, dessen Kohlenstoffkette durch 1 oder 2 Ethersauerstoffatome unterbrochen ist, oder einen Arylendialkylrest mit 8 - 14 Kohlenstoffatomen, wobei im Fall mehrkerniger Verbindungen die aromatischen Glieder durch eine Einfachbindung, durch -O-, -S-, $-SO_2-$, -CO-, $CR_2R_3$-, -N [$C_{1-2}$-Alkyl] CO- oder $C_{2-5}$-Alkyl, das durch Ethersauerstoffatome unterbrochen sein kann, ver bunden sein können und

$R_2$ und $R_3$ gleich oder verschieden sein können und Wasserstoff oder ggf. substituierte, z.B. ein oder mehrere fluorsubstituierte Alkylreste mit 1 oder 2 Kohlenstoffatomen bedeuten,

oder

R und $R_1$ zusammen durch einen Cycloalkylrest mit 4 - 16 Kohlenstoffatomen gebildet werden, wobei bei mehrkernigen Verbindungen die Cycloaliphaten durch eine Kohlenstoffkette von 1 - 6 Kohlenstoffatomen verbunden sein können

und

$D_1$ und $D_2$ gleich oder verschieden sind und 1,2-Naphthochinon-2-diazid-4- bzw. 5-sulfonylreste bedeuten.

**3.** Verwendung der Bis-1,2-naphthochinon-2-diazid-sulfonsäureamide nach Anspruch 1 als strahlungsempfindliche Komponenten in einem strahlungsempfindlichen Gemisch.

**4.** Verwendung nach Anspruch 3, dadurch gekennzeichnet, daß als strahlungsempfindliche Komponente 4- bzw. 5-Sulfonyl-Derivate allein oder im Gemisch oder 4,5-Mischsulfonyl-Derivate eingesetzt werden.

**5.** Verwendung nach Anspruch 4, dadurch gekennzeichnet, daß als strahlungsempfindliche Komponente ein Gemisch von 4- und 5-Sulfonyl-Derivaten eingesetzt wird.

**6.** Strahlungsempfindliches Gemisch, enthaltend ein polymeres wasserunlösliches, in wäßrig-alkalischer Lösung lösliches oder quellbares harzartiges Bindemittel und ein 1,2-Naphthochinon-2-diazid-sulfonsäurederivat dadurch gekennzeichnet, daß es als 1,2-Naphthochinon-2-diazid-sulfonsäurederivat mindestens eine Verbindung nach Anspruch 1 enthält.

**7.** Gemisch nach Anspruch 6, dadurch gekennzeichnet, daß es als 1,2- Naphthochinon-2-diazid-sulfonsäurederivat mindestens eine Verbindung nach Anspruch 2 enthält.

**8.** Gemisch nach Anspruch 6 oder 7, dadurch gekennzeichnet, daß der Anteil an strahlungsempfindlicher Komponente 4 bis 40 % bezogen auf den Feststoffanteil des Gemisches beträgt.

**9.** Strahlungsempfindliches Kopiermaterial, bestehend aus einem Schichtträger und einer strahlungsempfindlichen Schicht, dadurch gekennzeichnet, daß die Schicht aus einem Gemisch gemäß einem oder mehreren der Ansprüche 6 bis 8 besteht.

## Claims

**1.** Bis-1,2-naphthoquinone-2-diazide-sulfonic acid amides of secondary diamines, of the formula I

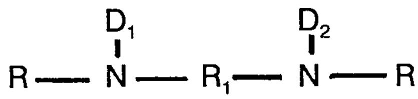

in which

R is a straight-chain or branched, unsubstituted or hydroxyl-substituted alkyl, cycloalkyl or aralkyl radical which has 1 to 14 carbon atoms and the carbon chain of which can be interrupted by ether oxygen atoms,

$R_1$ is an alkylene radical which has 2 to 12 carbon atoms and the carbon chain of which is interrupted by ether oxygen atoms, or is an arylene dialkyl radical having 8 to 18 carbon atoms, it being possible in the case of polynuclear compounds for the aromatic members to be linked by a single bond, by -O-, -S-, $-SO_2-$, -CO-, $-CR_2R_3-$, $-N[C_{1-3}$-alkyl]CO- or $C_{2-5}$-alkyl which can be interrupted by ether oxygen atoms, and

$R_2$ and $R_3$ can be identical or different and are hydrogen or unsubstituted or substituted alkyl radicals having 1 or 2 carbon atoms, or

R and $R_1$ together are formed by a cycloalkyl radical having 4 to 16 carbon atoms, it being possible in the case of polynuclear compounds for the cycloaliphatics to be linked by a carbon chain of 1 to 6 carbon atoms,

and

$D_1$ and $D_2$ are identical or different and are 1,2-naphthoquinone-2-diazide-4-or -5-sulfonyl radicals.

**2.** Bis-1,2-naphthoquinone-2-diazide-sulfonic acid amides of secondary diamines of the formula I, as claimed in claim 1, wherein

R is a straight-chain or branched, unsubstituted or hydroxyl-substituted alkyl or cycloalkyl radical which has 1 to 8, preferably 1 to 4, carbon atoms and the carbon chain of which can be interrupted by ether oxygen atoms, or is an aralkyl radical having 7 to 14 carbon atoms,

$R_1$ is an alkylene radical which has 2 to 10 carbon atoms and the carbon chain of which is interrupted by 1 or 2 ether oxygen atoms, or is an arylene dialkyl radical having 8 to 14 carbon atoms, it being possible in the case of polynuclear compounds for the aromatic members to be linked by a single bond, by -O-, -S-, $-SO_2-$, - CO-, $-CR_2R_3-$, $-N[C_{1-3}$-alkyl]CO- or $C_{2-5}$-alkyl which can be interrupted by ether oxygen atoms, and

$R_2$ and $R_3$ can be identical or different and are hydrogen or unsubstituted or substituted alkyl radicals having 1 or 2 carbon atoms, for example, alkyl radicals substituted by one or more fluorine atoms,

or

R and $R_1$ together are formed by a cycloalkyl radical having 4 to 16 carbon atoms, it being possible in the case of polynuclear compounds for the cycloaliphatics to be linked by a carbon chain of 1 to 6 carbon atoms,

and

$D_1$ and $D_2$ are identical or different and are 1,2-naphthoquinone-2-diazide-4-or -5-sulfonyl radicals.

**3.** The use of the bis-1,2-naphthoquinone-2-diazide-sulfonic acid amides as claimed in claim 1 as radiation-sensitive components in a radiation-sensitive mixture.

**4.** The use as claimed in claim 3, characterized in that the radiation-sensitive component used is a 4- or 5-sulfonyl derivate individually or in a mixture or a mixed 4,5-sulfonyl derivative.

**5.** The use as claimed in claim 4, characterized in that the radiation-sensitive component used is a mixture of 4- and 5-sulfonyl derivatives.

6. A radiation-sensitive mixture, containing a polymeric resinous binder which is insoluble in water and soluble or swellable in aqueous-alkaline solution, and a 1,2-naphthoquinone-2-diazide-sulfonic acid derivative, characterized in that it comprises at least one compound as claimed in claim 1 as the 1,2-naphoquinone2-diazide-sulfonic acid derivative.

7. A mixture as claimed in claim 6, characterized in that it comprises at least one compound as claimed in claim 2 as the 1,2-naphthoquinone-2-diazide-sulfonic acid derivative.

8. A mixture as claimed in claim 6 or 7, characterized in that the content of radiation-sensitive component is 4 to 40 %, relative to the solids content of the mixture.

9. A radiation-sensitive copying material, comprised of a layer support and a radiation-sensitive layer, characterized in that said layer is comprised of a mixture as claimed in one or several of claims 6 to 8.

## Revendications

1. Bis-1,2-naphtoquinone-2-diazide-sulfonamides de diamines secondaires, de formule générale I

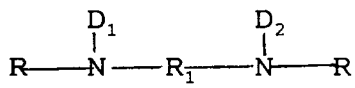

dans laquelle
R représente un groupe alkyle, cycloalkyle ou aralkyle ayant de 1 à 14 atomes de carbone, à chaîne linéaire ou ramifiée, éventuellement substituée par hydroxy, dont le squelette carboné peut être interrompu par des atomes d'oxygène de goupes éthers,
$R_1$ représente un groupe alkylène ayant 2 à 12 atomes de carbone, dont le squelette carboné est interrompu par des atomes d'oxygène de goupes éthers, ou un groupe arylènedialkyle ayant de 8 à 18 atomes de carbone, les membres aromatiques, dans le cas de composés polycyliques, pouvant être liés par une liaison simple, par -0-, -S-, $-SO_2-$, -CO-, $-CR_2R_3-$, $-N[C_{1-3}\text{-alkyl}]-CO-$ ou alkyle en $C_2$-$C_5$ qui peut être interrompue par des atomes d'oxygène de groupes éthers, et
$R_2$ et $R_3$ identiques ou différents représentent un atome d'hydrogène ou un groupe alkyle ayant de 1 à 2 atomes de carbone éventuellement substitué, ou
$R_1$ et $R_2$ représentent ensemble un groupe cycloalkyle ayant de 4 à 16 atomes de carbone, les composés cycloaliphatiques, dans le cas de composés polycycliques, pouvant être liés par un groupe hydrocarboné ayant de 1 à 6 atomes de carbone,
et
$D_1$ et $D_2$ identiques ou différents représentent un groupe 1,2-naphtoquinone-2-diazide-4- ou -5-sulfonyle.

2. Bis-1,2-naphtoquinone-2-diazide-sulfonamides de diamines secondaires de formule générale I selon la revendication 1, dans laquelle
R représente un groupe alkyle ou cycloalyle ayant de 1 à 8, de préférence 1 à 4 atomes de carbone à chaîne linéaire ou ramifiée, éventuellement substituée par hydroxy, dont le squelette hydrocarboné peut être interrompu par des atomes d'oxygène de groupes éthers, ou un groupe aralkyle ayant de 7 à 14 atomes de carbone,
$R_1$ représente un groupe alkylène ayant de 2 à 10 atomes de carbone, dont le squelette hydrocarboné est interrompu par 1 ou 2 atomes d'oxygène de groupes éthers, ou un groupe arylènedialkyle ayant de 8 à 14 atomes de carbone, les membres aromatiques pouvant dans le cas de composés polycycliques être liés par une liaison simple, par -0-, -S-, $-SO_2-$, -CO-, $-CR_2R_3-$, $-N[C_{1-2}\text{- alkyl}]CO-$ ou $C_2$-$C_5$ alkyle, qui peut être interrompue par des atomes d'oxygène de groupes éthers, et
$R_2$ et $R_3$ identiques ou différents représentent un atome d'hydrogène ou un groupe alkyle ayant 1 ou 2 atomes de carbone éventuellement substitué par exemple par un ou plusieurs atomes de fluor,
ou
$R_1$ et $R_2$ forment ensemble un groupe cycloalkyle ayant de 4 à 16 atomes de carbone, les composés cycloaliphatiques dans le cas de composés polycycliques pouvant être liés par une chaîne hydrocarbonée ayant de 1 à 6 atomes de carbone,

et
$D_1$ et $D_2$ identiques ou différents représentent un groupe 1,2-naphtoquinone-2-diazide-4- ou 5-sulfonyle.

**3.** Utilisation des bis-1,2-naphtoquinone-2-diazidesulfonamides selon la revendication 1 comme composants photosensibles dans un mélange photosensible.

**4.** Utilisation selon la revendication 3, caractérisée en ce que en tant que composants photosensibles, on utilise des dérivés 4- ou 5-sulfonyle seuls ou en mélange, ou des dérivés 4,5-sulfonyle mixtes.

**5.** Utilisation selon la revendication 4, caractérisée en ce qu'on utilise en tant que composants photosensibles, un mélange de dérivés 4- et 5-sulfonyle.

**6.** Mélange photosensible, contenant un liant de type résineux, polymère, insoluble dans l'eau, soluble ou gonflable dans des solutions aqueuses alcalines et un dérivé d'acide 1,2-naphtoquinone-2-diazide-sulfonique, caractérisé en ce qu'elle comprend comme dérivé d'acide 1,2-naphtoquinone-2-diazide-sulfonique, au moins un composé selon 1.

**7.** Mélange selon la revendication 6, caractérisé en ce qu'il comprend en tant que dérivé d'acide 1,2-naphtoquinone-2-diazide-sulfonique au moins un composé selon la revendication 2.

**8.** Mélange selon la revendication 6 ou 7, caractérisé en ce que la teneur en composants photosensibles est comprise entre 4 et 40 % par rapport aux solides du mélange.

**9.** Matériau de copiage photosensible, composé d'un support de couche et d'une couche photosensible, caractérisé en ce que la couche est composée d'un mélange selon une ou plusieurs des revendications 6 à 8.